Europäisches Patentamt

European Patent Office

Office européen des brevets

(19)

(11) EP 0 599 124 B1

(12) EUROPÄISCHE PATENTSCHRIFT

(45) Veröffentlichungstag und Bekanntmachung des Hinweises auf die Patenterteilung:
21.04.1999 Patentblatt 1999/16

(51) Int Cl.⁶: H04N 7/32

(21) Anmeldenummer: 93118117.6

(22) Anmeldetag: 09.11.1993

(54) **Verfahren zur Ermittlung von Prädiktionswerten bei der DPCM-Prädiktionscodierung sowie und Anwendung**

Method for determining prediction values in a DPCM predictive coding, as well asapplication

Méthode pour la détermination des valeurs de prédiction dans un codeur prédictif DPCM,application associés

(84) Benannte Vertragsstaaten:
AT CH DE FR GB LI NL

(30) Priorität: 23.11.1992 DE 4239267

(43) Veröffentlichungstag der Anmeldung:
01.06.1994 Patentblatt 1994/22

(73) Patentinhaber: ROBERT BOSCH GMBH
70442 Stuttgart (DE)

(72) Erfinder: Mayer, Jörg, Dipl.-Ing.
D-70374 Stuttgart (DE)

(56) Entgegenhaltungen:
WO-A-80/00207         DE-A- 2 432 399
US-A- 4 255 763

• SEVENTEENTH ANNUAL ALLERTON CONFERENCE ON COMMUNICATION, CONTROL, AND COMPUTING, Oktober 1979, MONTICELLO, ILL., US Seiten 896 - 903 COHEN ET AL 'EDGE-ADAPTIVE PREDICTIONS FOR DPCM CODING OF PICTURES'
• ADVANCES IN ELECTRONICS AND ELECTRON PHYSICS, SUPPL. 12, 1977, ORLANDO, US Seiten 73 - 112 MUSMANN 'Predictive Image Coding'

## Beschreibung

Die Erfindung betrifft ein Verfahren zur Ermittlung von Prädiktionswerten bei der DPCM-Prädiktionscodierung von Daten, insbesondere Bilddaten, sowie einen Prädiktor und die Anwendung des Verfahrens bzw. des Prädiktors.

Zur Datenreduktion von Signalen, insbesondere von Bildsignalen, wird häufig die Differenz-Pulscodemodulation (DPCM) verwendet. DPCM-Coder enthalten üblicherweise eingangsseitig einen Subtrahierer, dessen Minuendeneingang mit dem Eingangssignal-Bildsignal- und dessen Subtrahendeneingang mit einem Prädiktionssignal (Schätzwert) beaufschlagt ist.

Dem Subtrahierer ist ein Quantisierer nachgeschaltet, dessen Ausgang den Ausgang des DPCM-Coders bildet. Der Schätzwert wird zusammen mit dem Ausgangssignal des Quantisierers einem Addierer zugeführt, dem ein Prädiktor nachgeschaltet ist. Ein solcher Prädiktor verzögert das Additionssignal um die Länge einer Bildsequenz oder einem Vielfachen davon (DE 37 38 851 Al). Bei einem DPCM-Coder gemäß DE 36 42 394 Al wird ein aktueller Prädiktionswert durch Interpolation aus Abtastwerten gebildet, die drei Abtastintervalle vor bzw. nach diesem liegen. Bei einem eine Kante darstellenden Bildsignal wird der aktuelle Prädiktionswert durch Interpolation aus dem vorangegangenen Abtastwert und dem folgenden Abtastwert ermittelt.

Aus der US-A-4255 763 ist ein Verfahren zur Ermittlung von Prädiktionswerten bei einer DPCM-Prädiktionscodierung für Bilddaten bekannt, wobei die Prädiktion kantenadaptiv erfolgt. Dort wird aus zwei zeitlich zurückliegenden Prädiktionswerten ein aktueller Prädiktionswert ermittelt. Die dabei gebildete Differenz wird mit einem Schwellwert als Kantenkriterium verglichen. Es wird zwischen zwei verschiedenen Prädiktionsverfahren umgeschaltet und der jeweils günstigere Prädiktor gewählt.

Die DE-A-2432 399 offenbart ein ähnliches DPCM-Prädiktionsverfahren. Zur Prädiktion werden vier zeitlich aufeinanderfolgende Bildpunkte ausgewertet, wobei festgestellt wird, welcher dieser vier Bildpunkte die kleinste zeitliche Differenz zu einem aktuellen Bildpunkt hat. Im Bereich von Kanten erfolgt eine Mitteilung über mehrere Differenzen, die einen gewissen Betrag nicht überschreiten.

Aufgabe der Erfindung ist es ein Verfahren für eine verbesserte Prädiktion anzugeben, insbesondere für den Fall, daß aufeinanderfolgende Prädiktionswerte auf den gleichen Prädiktionsfehler führen. Außerdem soll eine Anwendung aufgezeigt werden. Diese Aufgabe wird hinsichtlich des Verfahrens durch die Schritte des Patentanspruchs 1 und hinsichtlich der Anwendung durch den Patentanspruch 7 gelöst. Die weiteren Patentansprüche betreffen Ausgestaltungen des Verfahrens.

Die Erfindung beruht auf folgenden Erkenntnissen: Bei der DPCM-Codierung mit nichtlinearer Kennlinie besteht das Problem, daß mittelschnelle Verläufe, wie z.B. Rampen, zu einem großen Prädiktionsfehler führen, der grob quantisiert wird, wenn der lineare Bereich der Kennlinie verlassen wird. Dabei kann es zur Oszillation des Quantisierfehlers zwischen zwei Repräsentativwerten kommen, der sich als Rauschen im dekodierten Signal niederschlägt. Darüber hinaus wird das Maximum der Häufigkeitsverteilung des Quantisierfehlers von 0 weggeschoben, was bei einer eventuellen Huffmann-Codierung von Nachteil ist. Durch die Maßnahmen nach der Erfindung läßt sich die Oszillation des Prädiktionsfehlers wirksam unterdrücken. Die Häufigkeitsverteilung des Prädiktionsfehlers hat bei Null ihren Maximalwert, was für eine Entropiecodierung, z.B. Huffmann-Codierung vorteilhaft ist. Die Erfindung ist insbesondere für "Composite"-Fernsehsignale mit beliebiger Abtastfrequenz geeignet. Der Farbträger läßt sich durch einfache Zusatzmaßnahmen bei der Aufbereitung des Prädiktionsfehlers unterdrücken. Durch die Freiheit bei der Wahl der Abtastfrequenz läßt sich das Prädiktionssignal problemlos in einem Grundcontainer der "Synchronen Digitalen Hierarchie" (SDH) unterbringen, ohne daß der Prädiktionfehler ansteigt. Die Erfindung wird nun anhand von Ausführungsbeispielen erläutert.

Es zeigen

Fig. 1 das Prinzip der DPCM-Codierung,
Fig. 2 eine Quantisierungskennlinie,
Fig. 3 ein Bildquellsignal in Form einer Rampe, die mit einem PAL Farbträger überlagert ist,
Fig. 4 der quantisierte Prädiktionsfehler ohne die Maßnahmen der Erfindung,
Fig. 5 die Häufigkeitsverteilung des Prädiktionsfehlers ohne die Maßnahmen der Erfindung,
Fig. 6 eine Realisierung eines Prädiktors nach der Erfindung,
Fig. 7 der quantisierte Prädiktionsfehler bei Anwendung der Maßnahmen nach der Erfindung,
Fig. 8 die Häufigkeitsverteilung des Prädiktionsfehlers bei Anwendung der Maßnahmen nach der Erfindung.

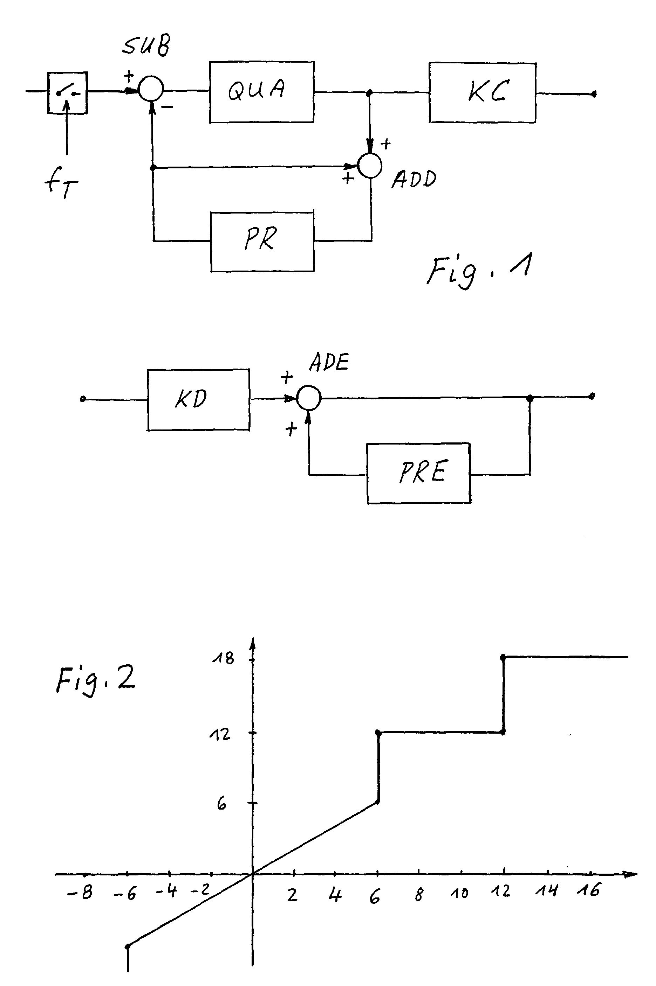

Wie Fig. 1 zeigt, ist für eine DPCM-Übertragung eine sendeseitige und eine empfangsseitige Signalaufbereitung vorgesehen. Bei der sendeseitigen Aufbereitung wird ein Quellsignal, z.B. eine Bild - und/ oder Tonsequenz, mit einer Abtastfrequenz $f_T$ abgetastet. Das abgetastete Quellsignal wird einem Subtrahierer SUB am Minuendeneingang zugeführt. Der Subtrahendeneingang des Subtrahierers SUB wird mit einem Prädiktionssignal, welches von einem Prädiktor PR geliefert wird, beaufschlagt. Am Ausgang des Subtrahierers SUB erscheint dann ein Prädiktionsfehlersignal, welches einem Quantisierer QUA zugeführt wird.Der Quantisierer quantisiert das Prädiktionsfehlersignal gemäß der in Fig. 2 dargestellten Quantisierungskennlinie. Im Bereich kleiner Quantisierungsfehler beispielsweise zwischen 0 und 6 wird linear quantisiert. Für Quantisierungsfehler $D_n$ mit n > 6 wird nur noch grob und nichtlinear quantisiert. Das Ausgangssignal des Quantisierers QUA wird, falls der Quantisierungsfehler übertragen werden soll, einem Kanalcoder KC, z.B. einem Entropiecoder mit Huffmann-Codierung, zugeführt, der neben der DPCM-Codierung eine weitere Datenreduktion erzielt.

Das Ausgangssignal des Quantisierers QUA wird über einen Addierer ADD dem Prädiktor PR zugeführt. Dieser Addierer ADD addiert zum Ausgangssignal des Quantisierers das durch den Prädiktor ermittelte Prädiktionssignal. Empfangsseitig muß eine zur sendeseitigen Aufbereitung entsprechende Rückwandlung erfolgen. Dazu ist, wie Fig. 1 zeigt, ein Kanaldecoder KD vorgesehen mit nachgeschaltetem Addierer ADE, der zum empfangenen Prädiktionsfehler den mit einem empfangsseitigen Prädiktor PRE ermittelten Prädiktionswert addiert. Am Ausgang der empfangsseitigen Aufbereitung ist entweder ein D/A-Wandler vorgesehen oder es erfolgt eine digitale Weiterverarbeitung des digitalen Empfangssignals.

Die Prädiktoren PR und PRE bestehen aus Verzögerungsgliedern und Verknüpfungsschaltungen, wobei die Verzögerung dieser Verzögerungsglieder gerade so gewählt ist, daß jeweils eine Verzögerung um eine Quellsequenz, z.B. Bilddauer, Halbbilddauer, oder Bildpunktabstand ermöglicht wird. Auf diese Weise können aktuelle Bilder oder Bildpunkte mit vorangehenden Bildern/Bildpunkte verglichen werden und die jeweiligen Änderungen zwischen Bild/Bildpunkt und Folgebildern/Folgebildpunkten, zu einem Prädiktionsfehlersignal aufbereitet werden. Gemäß einem ersten Schrift der Erfindung wird aus mindestens zwei zeitlich zurückliegende Prädiktionswerten $P_{n-2}$ und $P_{n-1}$,wobei n jeweils die Stelle des aktuellen Bildes/Bildpunktes angibt, ein aktueller Prädiktionswert $P_n$ ermittelt, indem zu einem zeitlich zurückliegenden Prädiktionswert $P_{n-1}$ die Differenz aus dem zeitlich zurückliegenden Prädiktionswert $P_{n-1}$ und einem zeitlich noch weiter zurückliegenden Prädiktionswert $P_{n-2}$ addiert wird. Für den aktuellen Prädiktionswert $P_n$ ergibt sich demnach $P_n = 2P_{n-1} - P_{n-2}$. Durch diese Art der Aufbereitung des aktuellen Prädiktionswertes läßt sich, wie später noch gezeigt wird, eine Oszillation des Prädiktionsfehlers vermeiden. Falls im Bildsignal jedoch Kanten auftreten, wird diese Art der Prädiktionsfehleraufbereitung durch eine andere Aufbereitung abgelöst, da in diesem Falle große Fehler auftreten würden. Zur Kantenerkennung wird die Differenz aus einem zeitlich zurückliegenden Prädiktionswert $P_{n-1}$ und einem zeitlich noch weiter zurückliegenden Prädiktionswert $P_{n-2}$ mit einem vorgegebenen Schwellwert T als Kantenkriterium verglichen. Wenn die Differenz $P_{n-1}$ - $P_{n-2}$ größer wird als der vorgegebene Schwellwert T wird als aktueller Prädiktionswert $P_n$ der zeitlich zurückliegende Prädiktionswert $P_{n-1}$ herangezogen.

Dieser erste Schritt der Erfindung wird nun weitergebildet insb. durch die Berücksichtigung des Farbträgers, hier des PAL-Farbträgers, einer günstigen und einfachen Kanalcodierung sowie einer vorteilhaften Realisierung der Prädiktoren PR und PRE.

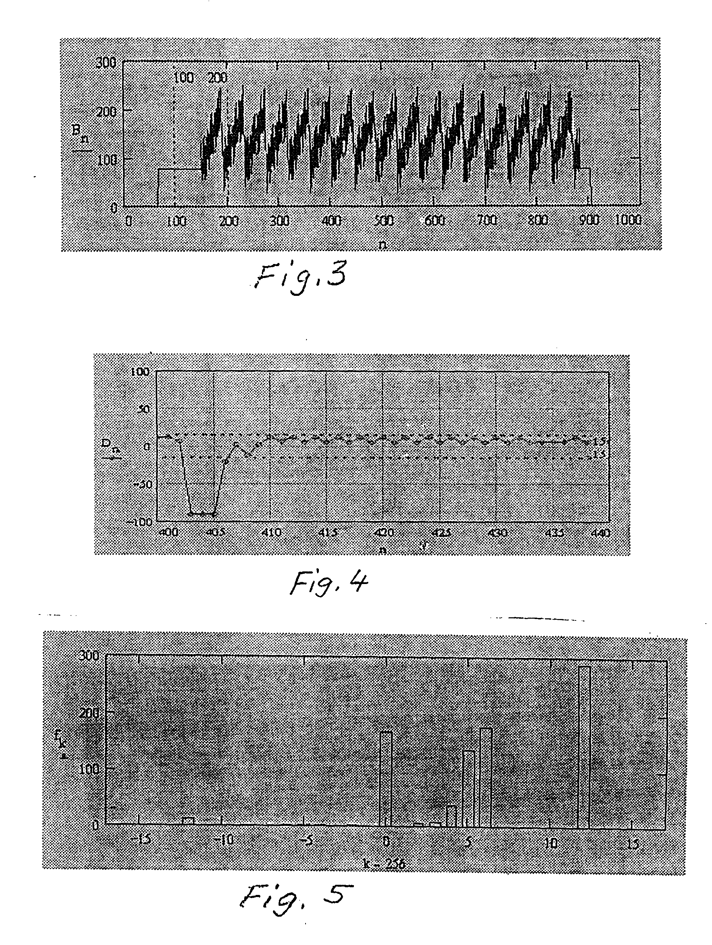

Fig. 3 zeigt als Beispiel für ein zu verarbeitendes Quellsignal ein Bildsignal in Form einer Rampe mit einer Periodendauer von 3 µs, die mit einem PAL-Farbträger überlagert ist. Die Abtastfrequenz beträgt $f_T$ = 14,14 MHz. Diese Abtastfrequenz ist besonders günstig für die Unterbringung von 2 FBAS-TV Signalen in einem SDH-Grundcontainer. Die Abtastfrequenz von 14,14 MHz ist kein ganzzahliges Vielfaches der PAL Farbträgerfrequenz von 4,434 MHz. Übliche Verfahren verwenden zur Abtastung stets ein ganzzahliges Vielfaches der Farbträgerfrequenz, damit der Prädiktionsfehler gering wird (DE 3642 394 A1, US 4,137,549). Durch eine vorteilhafte Ausbildung des Prädiktors nach der Erfindung kann erreicht werden, daß die Prädiktion nicht durch ein quasi-stationäres Farbhilfsträgersignal gestört wird. Bei Einhaltung der Bedingung:

$$P_n = P_{n-3} + 0,222 (P_{n-1} - P_{n-2})$$

ist der störende Einfluß des Farbhilfsträgers kompensiert, ohne daß dessen Informationsgehalt verloren geht. Der aktuelle Prädiktionswert (Schätzwert) $P_n$ entsteht also aus dem Prädiktionswert für den vorvorletzten Bildpunkt und der mit dem Faktor 0,222 gewichteten Differenz der Prädiktionswerte des letzten und vorletzten Bildpunktes. Diese Bedingung - speziell der Gewichtungsfaktor - gilt natürlich speziell für einen PAL-Farbträger. Bei anderen Fernsehsystemen, z.B. bei NTSC, läßt sich eine solche Unterdrückung von Farbträgerstörungen ebenso ermitteln. Der quantisierte Prädiktionsfehler ist aber trotz vorgenannter Maßnahme noch nicht optimal für eine Übertragung. Wie Fig. 4 zeigt, oszilliert der Prädiktionsfehler $D_n$ bei einer 4,5 Bit Kennlinie mit linearem Bereich von 0...6 und den Grobquantisierungswerten 12,21,34,53,78 (gefaltet und zu Null symmetrisch) nach einer Einschwingphase ab n = 410 zwischen 6 und 12. Daraus ergibt sich für den Bereich des Rampenanstiegs ein Störabstand von 38 5 dB. Die dazugehörige zu Null unsymmetrische Häufigkeitsverteilung $f_K$ zeigt Fig. 5.

Durch eine erfindungsgemäße adaptive Konturennachführung läßt sich dieses ungünstige Verhalten verbessern. Die adaptive Konturennachführung berücksichtigt zusätzlich zur Farbträgerunterdrückung nach vorgenannter Bedingung die Steigung des Luminanzsignals und kompensiert sie. Hierzu wird das FBAS - Signal mittels eines FIR - Filters mit 3 Anzapfungen und den Koeffizienten 0,36; 0,28 und 0,36 vom Farbhilfsträger befreit. Die Steigung - Schätzwert $S_{(n)}$ - des Luminanzsignals an der Stelle n · $S_{(n)}$ wird durch die Luminanzwerte $L_{(n-2)}$ - $L_{(n-3)}$ angenähert. Zur Berechnung der Steigung sind vier Verzögerungsglieder erforderlich, von denen drei bereits aus der Bedingung der Prädiktion für die Unterdrückung des störenden Einflusses des Farbhilfsträgers bekannt sind : (n - 1), (n-2), (n-3). Damit ergibt sich für den Prädiktor insgesamt folgende Beziehung :

$P_n = P_{n-3} + a (P_{n-1} - P_{n-2}) + b \cdot S_{(n)}$ oder ausführlich :
$P_n = P_{n-3} + a (P_{n-1} - P_{n-2}) + b [c (P_{n-1} - P_{n-2} + P_{n-3} - P_{n-4}) + d (P_{n-2} - P_{n-3})]$. Für a = 0,222; b = 2,778; c = 0,36 und d = 0,28 ist der Schätzwert für $P_n$ optimiert. Der Klammerausdruck mit welchem der Gewichtungsfaktor b multipliziert wird stellt die geschätzte Steigung S dar. Sie ist S, wenn gilt $0 \leq I S_{(n)} I \leq T$.

Wie zuvor ausgeführt wird T = 6 gewählt. Dadurch werden Einschwingvorgänge bei großen Sprüngen begrenzt.

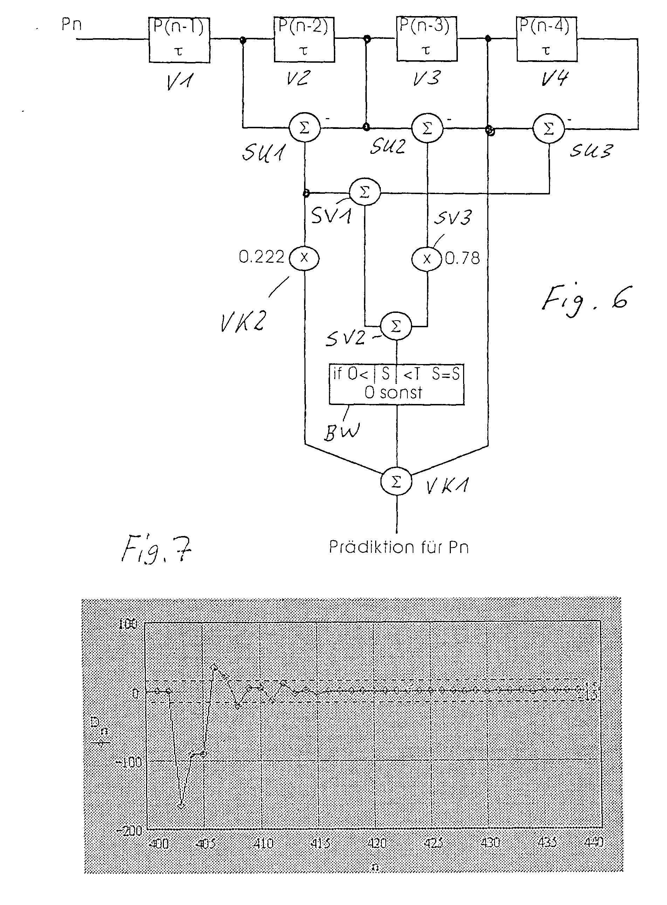

Fig. 6 zeigt eine mögliche Realisierung eines Prädiktors nach der obigen Bedingung für $P_n$ auf. Die in Kette geschalteten Verzögerungsglieder V1, V2, V3 und V4 verzögern das Eingangssignal $P_n$ jeweils um die Länge $\tau$ einer Bilddatensequenz beispielsweise dem Abstand eines Bildpunktes vom vorhergehenden Bildpunkt. Die Subtrahierer SU1, SU2, SU3 bilden die Differenz der Ausgangssignale jeweils benachbarter Verzögerungsglieder. Das Ausgangssignal SU1 wird im Netzwerk VK2 mit dem Faktor a gewichtet und einer ausgangsseitigen Summierstufe VK1 zugeführt. Der Verbindungspunkt zwischen den Verzögerungsgliedern V3 und V4 ist ebenfalls an diese Summierstufe VK1 angeschlossen. Zur Ermittlung des Schätzwertes für die Steigung werden die Ausgangssignale der Subtrahierer SU1 und SU3 im Summierer SV1 miteinander verknüpft. Das Ausgangssignal des Subtrahierers SU2 wird im Netzwerk SV3 mit dem Faktor 0,78 bewertet. Dieser Faktor ergibt sich durch Multiplikation des Faktors b = 2,778 mit dem Faktor d = 0,28. Die Ausgangssignale der Netzwerke SV1 und SV3 werden mittels Addierer SV2 verknüpft und einer Bewertungsschaltung BW zugeführt, die den Schätzwert für die Steigung nur innerhalb des Bereiches $0 \leq I S_{(n)} I \leq T$ bewertet und sonst unterdrückt. Der Schwellwert T wird vorzugsweise im Bereich zwischen 6 und 18 gewählt. Der Ausgang der Bewertungsschaltung BW führt ebenfalls zur ausgangsseitigen Summierstufe VK1, die die Prädiktion für den Subtrahierer SUB gemäß Fig. 1 liefert.

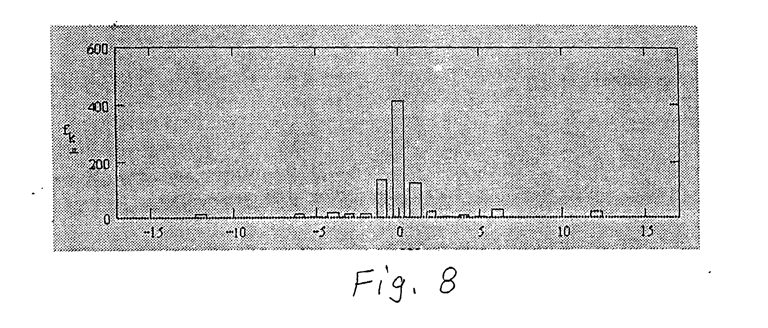

Wie Fig. 7 zeigt, schwingt der quantisierte Prädiktionsfehler $D_n$ bei Verwendung des Prädiktors nach Fig. 6 auf 0 ein. Der Störabstand für den Teil der Rampe verbessert sich um 17,2 dB auf 55,7 dB, was dem PCM-Wert entspricht.

Wie Fig. 8 zeigt, fällt das Maximum der Häufigkeitsverteilung $f_K$ des Prädiktionsfehlers auf 0. Außerdem ist die Häufigkeitsverteilung zu 0 symmetrisch. Eine sich anschließende Entropiecodierung ist so einfach möglich.

Das Verfahren nach der Erfindung ist nicht nur auf die Verarbeitung von Bildsignalen und/oder der Unterdrückung des Farbträgers beschränkt. In allen Signalen, in denen Zusatzsignale insbesondere in Frequenzverkämmung eingelagert sind, können bei der DPCM-Codierung die Maßnahmen nach der Erfindung vorteilhaft eingesetzt werden, z.B. bei der Toncodierung für Aufzeichnungszwecke.

Die Maßnahmen nach der Erfindung ermöglichen Prädiktionen sowohl in horizontaler Richtung als auch in vertikaler oder zeitlicher Richtung, d.h. beispielsweise Prädiktionen von Bildpunkten, -zeilen (intraframe prediction) oder Bildern (interframe prediction). Die Verzögerungsglieder sowie die Gewichtsfaktoren müssen dafür nur entsprechend angepaßt werden. Für horizontale Richtungen weisen sie Verzögerungszeiten vom Vielfachen des Bildpunktabstandes auf und bei vertikalen Richtungen Verzögerungszeiten von Vielfachen der Zeilendauer.

**Patentansprüche**

1. Verfahren zur Ermittlung von Prädiktionswerten bei einer DPCM-Prädiktionscodierung für Daten, insbesondere Bilddaten, mit folgenden Schritten:

   - aus mindestens drei zeitlich zurückliegenden Prädiktionswerten ($P_{n-3}$, $P_{n-2}$, $P_{n-1}$) wird ein aktueller Prädiktionswert ($P_n$) ermittelt, indem zu einem zeitlich zurückliegenden Prädiktionswert ($P_{n-3}$) die Differenz aus dem zeitlich zurückliegenden Prädiktionswert ($P_{n-1}$) und einem zeitlich noch weiter zurückliegenden Prädiktionswert ($P_{n-2}$) addiert wird,

   - die Differenz aus dem zeitlich zurückliegenden Prädiktionswert ($P_{n-1}$) und dem zeitlich noch weiter zurückliegenden Prädiktionswert ($P_{n-2}$) wird mit einem vorgegebenen Schwellwert (T) als Kantenkriterium verglichen,

   - wenn die Differenz ($P_{n-1} - P_{n-2}$) größer wird als der vorgegebene Schwellwert (T) wird als aktueller Prädiktionswert ($P_n$) der zeitlich zurückliegende Prädiktionswert ($P_{n-1}$) herangezogen,

   - zu einem so ermittelten Prädiktionswert ($P_n$) wird zusätzlich noch der mit einem Gewichtungsfaktor gewichtete aktuelle Schätzwert ($S_{(n)}$) für die Steigung eines Datensignals addiert, insbesondere eines Luminanzsignals, welcher aus der Summe der Differenzen jeweils mehrerer zeitlich zurückliegender Prädiktionswerte ($P_{n-1}$, $P_{n-2}$; $P_{n-3}$, $P_{n-4}$) gewonnen wird.

2. Verfahren nach Anspruch 1, dadurch gekennzeichnet, daß ein aktueller Prädiktionswert ($P_n$) nach folgender Beziehung ermittelt wird:
   $P_n = P_{n-3} + a (P_{n-1} - P_{n-2}) + b \bullet S(n)$, mit $S_{(n)}$ = aktueller Schätzwert für die Steigung eines Datensignals, insbesondere eines Luminanzsignals, welche aus Differenzen mehrerer zeitlich zurückliegender Prädiktionswerte gewonnen wird, n = 1,2,3, ... und a und b = Gewichtungsfaktoren.

3. Verfahren nach Anspruch 2, gekennzeichnet durch folgende Bedingung für den Schätzwert S(n): für $0 \leq I\ S_{(n)}\ I \leq T$ gilt : $S_{(n)} = s_{(n)}$; $S_{(n)} = 0$ sonst, wobei T als Schwellwert vorzugsweise im Bereich von 6 bis 18 liegt.

4. Verfahren nach Anspruch 2 oder 3, dadurch gekennzeichnet, daß der Schätzwert $S_{(n)}$ folgendermaßen ermittelt wird: $S_{(n)} = c\ (P_{n-1} - P_{n-2} + P_{n-3} - P_{n-4}) + d\ (P_{n-2} - P_{n-3})$ mit c und d = Gewichtungsfaktoren.

5. Verfahren nach einem der Ansprüche 2 bis 4, dadurch gekennzeichnet, daß die Gewichtungsfaktoren a und b folgendermaßen gewählt werden: a = 0,222 und b = 2,778.

6. Verfahren nach Anspruch 4 oder 5, dadurch gekennzeichnet, daß die Gewichtungsfaktoren c und d folgendermaßen gewählt werden: c = 0,36 und d = 0,28.

7. Anwendung des Verfahrens nach einem der Ansprüche 1 bis 6 bei einem Übertragungssystem, insbesondere einem SDH-Systems, dessen Abtastfrequenz kein ganzzahliges Vielfaches der Farbträgerfrequenz ist.

## Claims

1. Method for determining predicted values in DPCM predictive coding for data, in particular video data, having the following steps:

   - a current predicted value ($P_n$) is determined from at least three chronologically preceding predicted values ($P_{n-3}$, $P_{n-2}$, $P_{n-1}$) by adding to a chronologically preceding predicted value ($P_{n-3}$) the difference between the chronologically preceding predicted value ($P_{n-1}$) and a chronologically even further preceding predicted value ($P_{n-2}$),
   - the difference between the chronologically preceding predicted value ($P_{n-1}$) and the chronologically even further preceding predicted value ($P_{n-2}$) is compared with a predetermined threshold value (T) as edge criterion,
   - if the difference ($P_{n-1} - P_{n-2}$) becomes greater than the predetermined threshold value (T), the chronologically preceding predicted value ($P_{n-1}$) is used as the current predicted value ($P_n$),
   - a predicted value ($P_n$) determined in this way has added to it, in addition, the current estimated value ($s_{(n)}$) for the gradient of a data signal, in particular of a luminance signal, which estimated value is weighted with a weighting factor and is obtained from the sum of the differences between in each case a plurality of chronologically preceding predicted values ($P_{n-1}$, $P_{n-2}$; $P_{n-3}$, $P_{n-4}$).

2. Method according to Claim 1, characterized in that a current predicted value ($P_n$) is determined in accordance with the following relationship: $P_n = P_{n-3} + a\ (P_{n-1} - P_{n-2}) + b \bullet S(n)$, where $S_{(n)}$ = current estimated value for the gradient of a data signal, in particular of a luminance signal, which gradient is obtained from the differences between a plurality of chronologically preceding predicted values, n = 1,2,3, ... and a and b = weighting factors.

3. Method according to Claim 2, characterized by the following condition for the estimated value $S_{(n)}$: for $0 \leq I\ S_{(n)}\ I \leq T$, the following holds true: $S_{(n)} = S_{(n)}$; $S_{(n)} = 0$ otherwise, where T as threshold value preferably lies in the range from 6 to 18.

4. Method according to Claim 2 or 3, characterized in that the estimated value $S_{(n)}$ is determined as follows: $S_{(n)} = c\ (P_{n-1} - P_{n-2} + P_{n-3} - P_{n-4}) + d\ (P_{n-2} - P_{n-3})$ where c and d = weighting factors.

5. Method according to one of Claims 2 to 4, characterized in that the weighting factors a and b are chosen as follows: a = 0.222 and b = 2.778.

6. Method according to Claim 4 or 5, characterized in that the weighting factors c and d are chosen as follows: c = 0.36 and d = 0.28.

7. Application of the method according to one of Claims 1 to 6 in a transmission system, in particular an SDH system, whose sampling frequency is not an integer multiple of the colour subcarrier frequency.

## Revendications

1. Procédé pour déterminer les valeurs prévisionnelles d'un codage prévisionnel DPCM pour des données, notamment des données d'image, comprenant les étapes suivantes :

   - à partir d'au moins deux valeurs prévisionnelles en retard dans le temps ($P_{n-3}$, $P_{n-2}$, $P_{n-1}$) on forme une valeur prévisionnelle actuelle ($P_n$) en additionnant à une valeur prévisionnelle en retard dans le temps ($P_{n-3}$), la différence de la valeur prévisionnelle en retard dans le temps ($P_{n-1}$) et d'une valeur prévisionnelle encore plus en retard dans le temps ($P_{n-2}$),

- on compare la différence de la valeur prévisionnelle en retard dans le temps ($P_{n-1}$) et de la valeur prévisionnelle encore plus en retard dans le temps ($P_{n-2}$), avec un seuil prédéterminé (T) constituant un critère de bord, et
- si la différence ($P_{n-1} - P_{n-2}$) est supérieure au seuil prédéterminé (T), on prend comme valeur prévisionnelle actuelle ($P_n$) la valeur prévisionnelle en retard dans le temps ($P_{n-1}$),
- à la valeur prévisionnelle ainsi obtenue ($P_n$) on additionne en plus la valeur actuelle ($S_{(n)}$), pondérée par un coefficient de pondération pour la pente d'un signal de données, notamment d'un signal de luminance obtenu à partir de la somme des différences de plusieurs valeurs prévisionnelles en retard dans le temps ($P_{n-1}$, $P_{n-2}$, $P_{n-3}$, $P_{n-4}$).

2. Procédé selon la revendication 1,
caractérisé en ce qu'
on détermine une valeur prévisionnelle actuelle ($P_n$) selon la relation suivante :
$P_n = P_{n-3} + a (P_{n-1} - P_{n-2}) + b \cdot S(n)$, avec ($S_{(n)}$) = valeur évaluée actuelle pour la pente d'un signal de données, notamment d'un signal de luminance résultant des différences de plusieurs valeurs prévisionnelles en retard dans le temps, n = 1,2,3... et a et b = des coefficients de pondération.

3. Procédé selon la revendication 2,
caractérisé par
la condition suivante pour la valeur évaluée S(n) :
pour $0 \le I S_{(n)} I \le T$ on a : $S_{(n)} = S_{(n)}$;
pour tout autre cas $S_{(n)} = 0$,
dans ces relations, T est le seuil compris de préférence dans une plage entre 6 et 18.

4. Procédé selon la revendication 1 ou 3,
caractérisé en ce que
la valeur évaluée $S_{(n)}$ se détermine comme suit :
$S_{(n)} = c (P_{n-1} - P_{n-2} + P_{n-3} - P_{n-4}) + d (P_{n-2} - P_{n-3})$,
avec c et d = coefficients de pondération.

5. Procédé selon l'une des revendications 2 à 4,
caractérisé en ce que
les coefficients de pondération a et b sont choisis comme suit
a = 0,222 et b = 2,778.

6. Procédé selon les revendications 4 et 5,
caractérisé en ce que
les coefficients de pondération c et d sont choisis comme suit :
c = 0,36 et d = 0,28.

7. Application du procédé selon l'une quelconque des revendications 1 à 6 à un système de transmission, notamment un système SDH dont la fréquence de détection n'est pas un multiple entier de la fréquence de la porteuse couleur.

Fig. 1

Fig. 2

Fig. 3

Fig. 4

Fig. 5

Fig. 6

Fig. 7

Prädiktion für Pn

Fig. 8